Europäisches Patentamt

**European Patent Office**

**Office européen des brevets**

(19)

(11) Publication number: **0 225 586**
**A1**

## EUROPEAN PATENT APPLICATION

(12)

(21) Application number: **86116742.7**

(22) Date of filing: **02.12.86**

(51) Int. Cl.⁴: **H 01 L 27/02**

(30) Priority: **03.12.85 IT 2307785**

(43) Date of publication of application: **16.06.87**
**Bulletin 87/25**

(84) Designated Contracting States: **DE FR GB NL**

(71) Applicant: **SGS MICROELETTRONICA S.p.A., Stradale Primosole 50, I-95121 Catania (IT)**

(72) Inventor: **Cappelletti, Paolo Guiseppe, Dr., C.so Garibaldi, 104, I-20030 Seveso (MI) (IT)**
Inventor: **Colli Lanzi, Gabriele, Via Meina, 5, I-20125 Milano (IT)**

(74) Representative: **Klunker . Schmitt-Nilson . Hirsch, Winzererstrasse 106, D-8000 München 40 (DE)**

(54) **An overvoltage protection circuit for an integrated MOS device.**

(57) A device for protecting a circuit against input overvoltages for an integrated MOS circuit having a low supply voltage and high integration density and including at least one IGFET with gate oxides of a thickness of not more than 50 nm. The protection device comprises a first ($T_1'$) and a second lateral bipolar transistor ($T_2'$) the collectors of which are connected to the input terminal (IN') of the circuit and the gate electrodes of the IGFETs, repsectively, and the emitters of which are both connected to ground. A diffused resistor (R') couples the collectors of the two lateral transistors ($T_1'$, $T_2'$). The base width of the first transistor ($T_1'$) and the impurity concentration of the bases of the two lateral transistors ($T_1'$, $T_2'$) are such that the ignition voltage ($LV_{CEO}$) at which a negative resistance of the first lateral transistor ($T_1'$) is initiated, and the breakdown voltage of the second lateral transistor ($T_2'$) are maintained at a value lower than the breakdown voltage of the insulating gate oxides and the breakdown voltage of the bipolar junction included within the integrated circuit, and that the sustaining voltage of the first lateral transistor ($T_1'$) is kept at a value higher than the supply voltage of the integrated circuit.

## An overvoltage protection circuit for an integrated MOS device

Specification:

This invention relates to a protection device for protecting a MOS-type (metal oxide semiconductor) integrated circuit against accidental input overvoltages, wherein said MOS circuit has a high integration density and a low supply voltage and comprises insulated gate field effect transistors in which the thickness of the insulating gate oxide is equal to or less than 50 nm.

Integrated MOS circuits have an extremely high input impedance, which is typically greater than $10^{14}$ ohm, while the input capacitance is in the order of $10^{-12}$ F. Therefore, the MOS circuits are particularly sensitive to accumulations of static charges. This disadvantage is the more evident the higher the integration density of the integrated MOS circuit is, since the channels are shorter, the junctions are less deep and the gate insulation is thinner. While electrical fields in the order of $10^7$ V/cm cause breakdown of or damage to the silicon oxide, the gate oxides used in devices of high integration density which are substantially thin already show such a disadvantage at voltages of 25-30 V.

During the process steps of fabrication, monitoring, assembling and further operations related to the making of the devices it is impossible, or at least very difficult, to avoid overvoltages within said range of magnitudes, because of accumulations of electrostatic charges. The accidentally induced electrostatic charges, mainly caused by careless handling, create very high electrical fields which provoke a breakdown of bipolar junctions present within the circuit as well as damage to the gate oxide of the IGFET within random zones. The probability of such breakdowns and damage increases as the thickness of the oxides decreases.

A device for protecting integrated MOS circuit against input overvoltages comprising IGFETs must attenuate accidental overvoltages to a value which is lower than the breakdown voltage of the gate oxides of the IGFETs and lower than the breakdown voltage of the bipolar junctions present within the circuit.

The input overvoltages, even if produced several times, must not damage the protection device and, therefore, there must be a greatly reduced power dissipation of the protection device itself during the discharge of electrostatic charges, while the power dissipation must take place in each case very uniformly at various points, thereby minimizing the thermal effects on the parts connected thereto. In an input protection device of an integrated circuit neither the overall quality of the circuit nor the operating speed of the circuit must be impaired. The protection device must have small dimensions, use a minimum number of elements and occupy the smallest possible area on the integrated circuit chip in which it is incorporated.

German Offenlegungsschrift DE 31 45 592 of the applicant of the present application discloses a protection device which is particularly adapted to be integrated monolithically into an integrated MOS circuit to be protected.

This device substantially comprises a lateral NPN transistor the emitter and collector of which are doped simultaneously and identically for N-type conductivity together with the source and drain regions, respectively, of an IGFET within the MOS circuit to be protected, while a buried base region is doped strongly and deeply with acceptor ions (P-type impurity) using ion implantation.

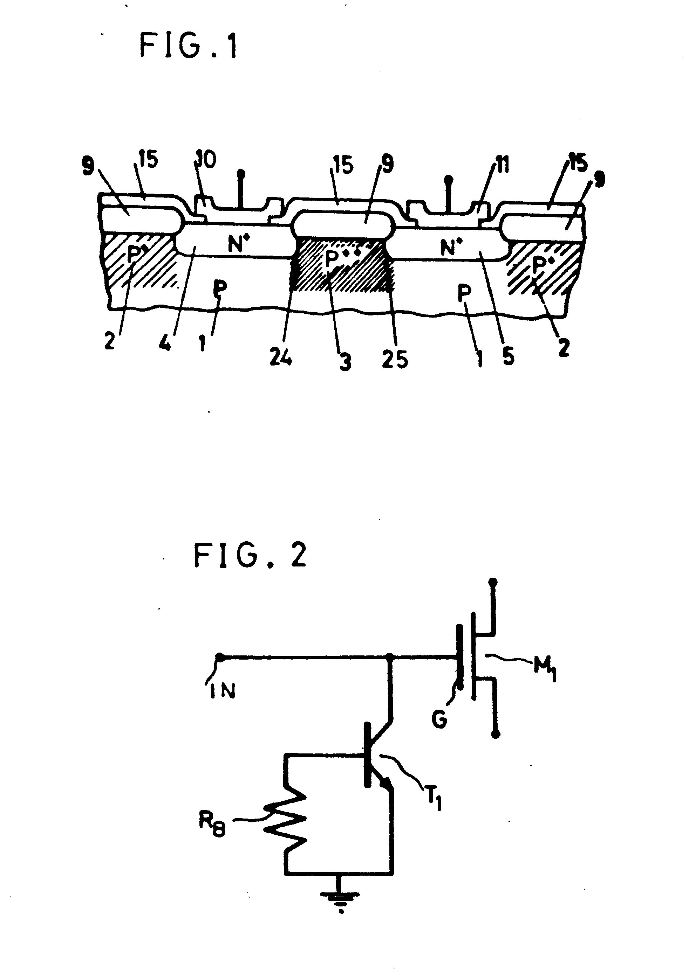

Fig. 1 of the attached drawings is an enlarged cross-sectional view of a structure of a protection device suitable for insertion into an integrated MOS circuit. The structure shown in Fig. 1 comprises a substrate 1 of monocrystalline silicon doped with P-type impurity, in which are formed two regions 4 and 5, highly doped with N-type impurity (indicated in the Fig. by $N^+$), which are separated by a region 3, which is highly doped with P-type impurity ($P^{++}$). Said regions 4, 3 and 5 constitute two bipolar adjoining and parallel junctions, indicated by 24 and 25 in the drawing.

The regions adjacent to the structure formed by said regions 4, 3 and 5 forming part of said field and indicated by reference numeral 2 in Fig. 1, are doped with P-type impurity. However, the impurity concentration of this region is higher than that of substrate 1 and lower than that of region 3 (in Fig. 1 the doping of zone 2 is indicated by $P^+$). Regions 2 and 3, which are indicated in Fig. 1 by wide and narrow hatching, respectively, are completely covered by a layer 9 of silicon dioxide. On the top of the oxide layer there is formed a further layer of an insulating and protective material, known as "P-vapox" material, which completely covers the oxides and the diffused regions, with the exception of the contacting areas of the electrode.

Electrodes 10 and 11 of regions 4 and 5, respectively, are connected to ground and to the connecting means between the input terminal and the circuit to be protected, respectively.

Fig. 2 shows the equivalent circuit diagram of the structure shown in Fig. 1. The pair of parallel bipolar junctions 24 and 25 is shown in the form of a transistor $T_1$ in which said regions 3, 4 and 5 form the base, the emitter and the collector, respectively.

The emitter is electrically connected to circuit ground. The collector is connected to the input terminal IN and to the gate electrode of the IGFET to be protected. The base of transistor $T_1$ corresponds to region 3 without any electrode, while in the circuit diagram the base is coupled to circuit ground through a resistor $R_B$, which represents the resistance of the body of the semiconductor material. Fig. 2 shows one IGFET $M_1$, which is representative of an internal integrated circuit to be protected.

In the normal operation mode, when only the signal is present at the input terminal, the base-to-emitter junction is not biassed and is therefore non-conductive. If, an accidental overvoltage is applied to input terminal IN, e.g. caused by an accumulation of electrostatic charges, the collector-to-emitter voltage exceeds the breakdown voltage of the transistor which, due to electrons accelerated by the force of the generated electrical field, has an avalanche effect. A breakdown takes place in transistor $T_1$ and the collector current rapidly increases. The collector current causes a voltage drop at the base resistor ($r_{bb'}$) of the transistor, whereby the emitter junction is forward-biassed. Hence, injected charges from the emitter region increase the total collector current, while the collector-to-emitter voltage remains unchanged. Therefore, the lateral transistor shows the characteristics of a negative resistance.

Ignition of such negative resistance phenomenon takes place at a value of the collector-to-emitter voltage ($LV_{CEO}$) which is somewhat above the breakdown voltage. The "negative resistance" phenomenon causes a rapid drop of the voltage $V_{CE}$ to a value $V_S$ below the breakdown voltage.

Within a large range of current values said value of the collector-to-emitter voltage remains almost constant, further increasing the collector current. The flow of a current having a value which is still very high between the emitter and the collector, while the collector-to-emitter voltage remains constant, is known as the "sustaining" phenomenon.

Even if there are overvoltages at the input terminal, the gate electrodes of the transistors included in the integrated MOS circuit protected by the device, and connected to the collector electrode of transistor $T_1$, theoretically do not receive voltages greater than a maximum collector-to-emitter voltage of transistor $T_1$ which is

equal to the ignition voltage ($LV_{CEO}$) of the negative resistance phenomenon.

The breakdown voltage $BV_{CEO}$ between the collector and the emitter of protection transistor $T_1$ is determined by the acceptor ion concentration within the base region of the transistor.

The ignition voltage $LV_{CEO}$ of the negative resistance phenomenon and the sustaining tension are determined both by said concentration and by the width of the base region.

Finally, the value of the sustaining current is determined by the length of the pn junctions.

Ion implantation of the base region allows for the breakdown voltage and said ignition voltage of the negative resistance phenomenon of lateral transistor $T_1$ to be exactly set at a value below both the breakdown voltage at which the gate oxide is destroyed and the breakdown voltage of the bipolar junctions of the integrated circuit to be protected.

The dose of implanted acceptor ions within the base determines also the value of the sustaining voltage $V_S$, which is lower than the breakdown voltage and at which the collector-to-emitter voltage of the transistor is stabilized for high values of the collector current.

It is very important that voltage $V_S$ be higher than the supply voltage of the integrated device the protection circuit is part of. If this were not the case, the power supply, once it exceeds the breakdown voltage due to an uncritical overvoltage at the input terminal, would continue to deliver energy until the device is destroyed (breakdown). From the viewpoint of power dissipation the protection device, comprising two parallel bipolar junctions separated by a heavily doped zone, one of which is connected to circuit ground, shows most favorable behavior, especially when very high currents are flowing through the protection circuit. In such a protection device the current is uniformly distributed over the entire length of the protection device, thereby limiting the current density at single points to uncritical values.

However, it should be noted that a protection device of the above-described type is not fully satisfying when the waveform of the overvoltage at the input terminal of the circuit to be protected has a very rapidly increasing leading edge, i.e. when the transistors have an extremely high operating speed.

It is the object of the present invention to provide a protection device for protecting integrated MOS circuits with low supply voltage and high integration density against input overvoltages which provides improved and more effective protection against overvoltages as compared with the prior art devices.

This problem is solved by the protection device characterized by the features of the patent claims.

Embodiments of the present invention shall now be described in detail with reference to the accompanying drawings, in which:

Fig. 1    is an enlarged cross-sectional view of the above-
described protection device,

Fig. 2    is one of a plurality of possible circuit diagrams of the prior art protection device,

Fig. 3    is one of a plurality of possible circuit diagrams of a protection device according to the
present invention, and

Fig. 4    is an enlarged partial plan view of a preferred
embodiment of a protection device according to
the present invention.

In the drawings the same reference numerals are used for
the same parts.

A protection device according to the present invention
substantially comprises a first and a second lateral
transistor, both of NPN-type conductivity, and a diffused
resistor. These circuit elements are monolithically integrated into a MOS circuit to be protected. The emitters
and collectors of said transistors and the diffused resistor are heavily doped with N-type impurity simultaneously and identically together with the source and
drain regions of the IGFETs of the MOS circuit to be
protected. The bases of the two transistors are heavily
and deeply doped with P-type impurity by way of ion implantation.

The lateral transistors and the diffused resistor may be
realized by means of a process which is identical to that
disclosed in the above-mentioned Italian patent application. The structure of the first and second transistors may be realized in a manner already described in connection with Fig. 1 for the lateral transistor of the prior art protection device.

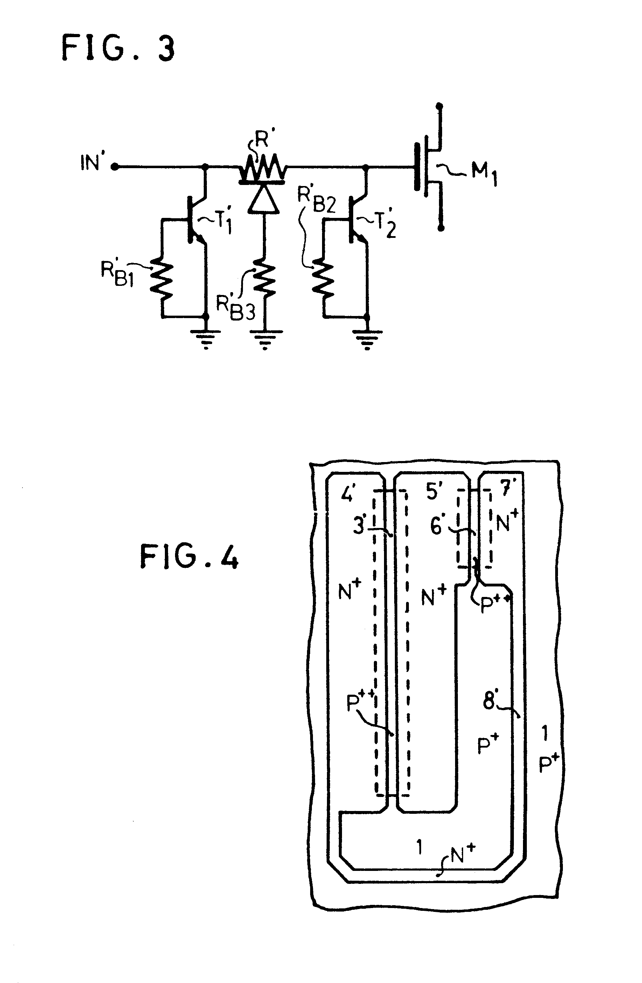

Fig. 4 shows an enlarged plan view of one preferred embodiment of a protection device according to the present invention. This embodiment is preferred in view of the integration process and structure.

This preferred embodiment of the protection device comprises a substrate 1 of monocrystalline silicon doped with P-type impurity. Within the substrate are formed three parallel regions 4', 5' and 7', each heavily doped with N-type impurity (this doping is indicated in the Fig. by $N^+$). Said parallel regions are separated from each other by two regions 3' and 6', each of which is heavily doped with P-type impurity ($P^{++}$) within the substrate is further formed a thin region 8', which is also heavily doped with N-type impurity ($N^+$) and connects region 4' with region 7'. Said regions 4' and 7' constitute the collectors of the first and second lateral transistors, respectively. Region 5' constitutes the emitters of the two transistors which are connected to each other. Regions 3' and 6' which are disposed between the aforementioned regions (and are partly located beneath regions 4', 5' and 7', as indicated by the broken lines in Fig. 4) constitute the bases of the first and second transistor, respectively.

Thin region 8' constitutes the diffused resistor which connects the collectors of the two lateral transistors.

The device is completed in the manner shown in Fig. 1 for the lateral transistor of the prior art device, i.e. by covering regions 3' and 6' with a relatively thick layer of silicon dioxide. In general, regions 7' and 8' are also covered by a layer of silicon dioxide. Finally, on the oxide layer there is formed a further layer of insulating and protecting material ("P-Vapox") to cover completely the oxides and the diffused regions with the exception of the contact areas of the electrodes.

The device comprises a first, a second and a third electrode (not shown in Fig. 4) which are connected to diffused region 4', to diffused region 5' and to diffused region 7', respectively. An insulating diffused region, realized by using well-known techniques, is also provided.

The protection device is inserted with its first and third electrode between the input terminal of the integrated circuit to be protected and those parts of the circuit which must be protected. The second electrode is electrically connected to the circuit ground of the integrated circuit.

The structure shown in Fig. 4 may be represented by the circuit diagram of Fig. 3. The circuit shown in Fig. 3 comprises a first bipolar transistor $T'_1$ of the NPN-type in which regions 4', 3' and 5' constitute the collector, the base and the emitter, respectively; a second bipolar transistor $T'_2$ of the NPN-type in which regions 7', 6' and 5' constitute the collector, the base and the emitter, respectively; and a resistor R' constituted by diffused region 8'.

/

The collector terminal of transistor $T'_1$ and the collector terminal of transistor $T'_2$ between which said resistor R' is inserted are connected to the input terminal IN of the circuit to be protected (with which transistors $T'_1$ and $T'_2$ are integrated) and to the gate electrodes, respectively, of the IGFETs included in said circuit. Fig. 3 only shows one IGFET $M_1$ which is representative of the internal integrated circuit to be protected. Further, in the circuit diagram of Fig. 3, diffused resistor R' is represented by a graphic symbol which is commonly used in the art for representing resistors of this type.

The bases of the two transistors $T'_1$ and $T'_2$ correspond to regions 3' and 6' without electrodes, and they are therefore shown in the circuit diagram connected to circuit ground through a first resistor $R'_{B1}$ and a second resistor $R'_{B2}$, respectively. These two resistors represent the intrinsic resistance of the semiconductor material of substrate 1.

Similarily, between resistor R' and circuit ground a third resistor $R'_{B3}$ is inserted. This third resistor represents the intrinsic resistance of the semiconductor material.

The values of said resistors depend on the geometry of the diffused regions and on the physical and electrical parameters of the integrated circuit. Also, the value of resistor R' must be determined as a function of the preset voltage thresholds and all parameters related both to lateral transistors $T'_1$ and $T'_2$ and to the remaining components of the integrated circuit. Its dimensioning is also effected empirically.

In the inventive protection device, transistor $T'_1$ which is directly connected to the input terminal IN of the circuit corresponds exactly to the lateral transistor which constitutes the prior art protection device shown in Fig. 1, as far as the physical characteristics, dimensioning and operation mode are concerned.

The purpose of second transistor $T'_2$, which in combination with diffused resistor R' characterizes the present invention, is to block high voltage peaks applied to first protection transistor $T'_1$ during extremely rapid transitions of input overvoltages. Although attenuated by the diffused resistor, said voltage peaks would otherwise be destructive for the gate oxides of the IGFETs of the MOS circuit to be protected.

Second transistor $T'_2$ need not necessarily satisfy the requirements of the first transistor. It is sufficient for the breakdown voltage of the second transistor to be lower than that of the thin oxide and of the bipolar junctions of the circuit to be protected, and not to be lower than the breakdown voltage of first transistor $T'_1$.

As shown in Fig. 4, the geometric dimensions of transistor $T'_2$ may be smaller than those of transistor $T'_1$, since transistor $T'_2$ need not sustain great current flows. In any case, the operation of this transistor is limited to short time intervals. For this reason the increased costs relating to the occupied integration area are negligible compared with the prior art device shown in Fig. 1.

According to the present invention it is important that diffused resistor R' be precisely realized so as to create a bipolar junction against the substrate, and not be realized, for example, in polycrystalline material. In this way, there are not only the effects of a delay line but also the effects of a diode with respect to this substrate (as is symbolically shown in Fig. 3 for diffused resistor R'), thereby allowing for an improved distribution of current flows into circuit ground as well during overvoltages. The dimensions of this resistor may be greatly limited as seen in Fig. 4. Therefore, the resistor does not essentially increase the costs of the device. Moreover, the resistor can be realized simultaneously with the emitter and the collector regions of the two lateral transistors.

In summary, a substantial improvement of the prior art protection device is achieved by a relatively simple remedy which is also economical from the point of view of its integration.

While the invention has been described with reference to a specific embodiment thereof, modifications will be apparent to those skilled in the art which do not depart from the spirit and the scope of the invention.

For example, transistor $T'_2$ shown in the circuit diagram of Fig. 3 may be replaced by a Zener diode in case it is unnecessary to ensure a uniformity of great current flows which is obtained by a second lateral transistor having a buried base. The anode is constituted by substrate 1 of Fig. 4 while the breakdown voltage of the diode is in this case also determined by means of ion implantation which determines the breakdown voltage between the emitter and the collector of lateral transistor $T'_1$.

SGS MICROELETTRONICI SPA
u.Z.: K 30 849SM/6-eb-D

2. Dezember 1986

Priority: Dec. 3, 1985 - No. 23077A/85 - Italy

An overvoltage protection circuit for an integrated
MOS device

## C L A I M S

1.   An integrated MOS circuit for a low supply voltage, having high integration density and comprising
three terminals, namely a first signal input terminal
(IN'), a second ground terminal, and a third power supply
terminal, at least one insulated gate field effect transistor (IGFET) the insulating gate oxide of which has a
thickness of not more than 50 nm, and a protection device
for protecting the circuit against input overvoltages,
the protection device including a first lateral bipolar
transistor ($T'_1$) having its collector coupled to said
input terminal (IN') and its emitter coupled to said ground terminal, and having a base region the width and the impurity concentration of which are such that the emitter-to-collector breakdown voltage as well as the ignition voltage ($LV_{CEO}$) at which a negative resistance of the first lateral transistor ($T'_1$) is initiated, are maintained at a value which is lower than the breakdown voltage of the gate insulating oxide and lower than the breakdown voltage of the bipolar junctions included within the integrated circuit, and that the sustaining voltage of the first lateral transistor is maintained at a value above the supply voltage of the integrated circuit, characterized in that said protection circuit comprises a second lateral bipolar transistor ($T'_2$) of the same conductivity type as said first lateral transistor ($T'_1$) and having a collector region connected to a gate electrode of said IGFET, an emitter region connected to ground and a base region the impurity concentration of which is such that the emitterto-collector breakdown voltage of the second lateral transistor ($T'_2$) is maintained at a value substantially equal to the emitter-to-collector breakdown voltage of said first lateral transistor ($T'_1$), said protection circuit further comprising a diffusion region type resistor which couples the collector region of the second lateral transistor ($T'_2$) to the collector region of the first lateral transistor ($T'_1$).

2. An integrated MOS circuit for a low supply voltage having high integration density and comprising three terminals, namely a first signal input terminal (IN'), a second ground terminal, and a third power supply terminal, at least one insulated gate field effect transistor (IGFET) the insulating gate oxide of which has a thickness of not more than 50 nm, and a protection device for protecting the circuit against input overvoltages, the protection device including a lateral bipolar transistor ($T'_1$) having its collector coupled to said first input terminal (IN') and its emitter coupled to said second ground terminal, and having a base region the width and the impurity concentration of which are such that the emitter-to-collector breakdown voltage as well as the ignition voltage ($LV_{CEO}$) at which a negative resistance of the first lateral transistor ($T'_1$) is initiated, are maintained below a value which is lower than the breakdown voltage of the gate insulating oxide and lower than the breakdown voltage of the bipolar junctions included within the integrated circuit, and that the sustaining voltage of the first lateral transistor is maintained at a value above the supply voltage of the integrated circuit, characterized in that said protection circuit comprises a Zener diode having a first region connected to the ground terminal and a second region connected to the gate electrode of the IGFET, the conductivity type of the second region being the same as that of the collector region of the lateral transistor ($T'_1$) and opposite to that of the first region of the Zener diode, the breakdown voltage of said diode being substantially equal to the emitter-to-collector breakdown voltage of the lateral transistor ($T'_1$), and that a diffusion region type resistor is provided which connects said second region of said diode to the collector region of the lateral transistor ($T'_1$).

½

FIG.1

FIG.2

FIG. 3

FIG. 4

**European Patent Office**

## EUROPEAN SEARCH REPORT

EP 86 11 6742

### DOCUMENTS CONSIDERED TO BE RELEVANT

| Category | Citation of document with indication. where appropriate, of relevant passages | Relevant to claim | CLASSIFICATION OF THE APPLICATION (Int Cl 4) |
|---|---|---|---|
| A | GB-A-2 133 926 (NEC CORPORATION) <br> * Figures 4-6; page 3, lines 5-120 * | 1,2 | H 01 L 27/02 |
| A | EP-A-0 130 412 (FUJITSU LIMITED) <br> * Figures 1,2; page 8, line 19 - page 11 * | 1,2 | |
| A | GB-A-2 151 846 (HITACHI LTD) <br> * Figures 3-5; page 3, lines 44-130 * | 1,2 | |
| A | FR-A-2 494 501 (SGS-ATES COMPONENTI ELETTRONICI SPA) <br> * Figure 3; Claim * & DE-A-3 145 592 (Cat. A,D) | 1,2 | |

**TECHNICAL FIELDS SEARCHED (Int Cl 4)**

H 01 L

The present search report has been drawn up for all claims

| Place of search | Date of completion of the search | Examiner |
|---|---|---|
| THE HAGUE | 05-02-1987 | CARDON A. |

EPO Form 1503 03 82